# EUROPÄISCHE PATENTSCHRIFT

(11) **EP 2 226 550 B1**
(45) Veröffentlichungstag und Bekanntmachung des Hinweises auf die Patenterteilung: **04.03.2015**
(21) Anmeldenummer: 10155454.1
(22) Anmeldetag: 04.03.2010
(51) Int. Cl.: F21V 29/00, F21K 99/00, F21V 29/56, F21S 4/00, F21Y 103/00, F21Y 101/02, H05K 1/14, H05K 1/18

(54) **LED-Leuchte mit Kühlkanal**
LED light with cooling channel
Lampe à DEL dotée d'un canal de refroidissement

(30) Priorität: 04.03.2009 DE 202009002977 U
(43) Veröffentlichungstag der Anmeldung: 08.09.2010
(73) Patentinhaber: Zumtobel Lighting GmbH, 6850 Dornbirn (AT)
(72) Erfinder: Eberle, Alfons, 6922 Wolfurt (AT); Gadner, Wolfgang, 6912 Hörbranz (AT)
(74) Vertreter: Thun, Clemens

(56) Entgegenhaltungen:
- EP-A1- 1 047 294
- EP-A1- 1 933 602
- CN-Y- 201 190 978
- NL-C2- 2 000 671
- US-A- 3 712 649
- US-A1- 2005 007 033
- US-A1- 2007 001 582

## Beschreibung

Die vorliegende Erfindung betrifft ein System mit mindestens zwei Anordnungen zur Lichtabgabe und mindestens einem Verbindungselement.

Leuchten mit Leuchtdioden als Leuchtmittel werden in den verschiedensten Bereichen der Beleuchtungstechnik immer häufiger eingesetzt. So kann eine längliche LED-Leuchte beispielsweise Leuchtstoffröhren ersetzen, wofür dann mehrere LEDs in Längsrichtung hintereinander auf einer Leiterplatte bzw. Platine angeordnet sind, wobei neben der geraden Anordnung auch eine zickzack- oder wellenförmige Anordnung der LEDs vorgesehen sein kann. Je nach gewünschtem Beleuchtungseffekt können hierbei dann farbige oder weiße LEDs zum Einsatz kommen.

Bei derartigen Leuchten ist die effektive Ableitung der von den Leuchtdioden erzeugten Wärme von entscheidender Bedeutung, da die erzielbare Lichtausbeute und Lebensdauer der LEDs sehr stark von der Betriebstemperatur abhängt. Hierbei ist es insbesondere wichtig, die Wärme so schnell wie möglich von den Halbleiterbauteilen abzuführen, wofür aus dem Stand der Technik bereits verschiedenste Lösungen bekannt sind, die auf dem Einsatz von Kühlkörpern oder aktiven Kühlelementen basieren. So kann beispielsweise vorgesehen sein, dass an den den Leuchtdioden gegenüberliegenden Seiten der Platinen Kühlkanäle insbesondere in Form von dort speziell angebrachten Rohren angeordnet sind. Durch diese Rohre strömt dann beispielsweise Wasser oder Luft als Kühlmedium um die von den LEDs erzeugte Wärme abzuleiten. Eine derartige Anordnung ist beispielsweise aus der US 2008/0062694 A1 bekannt.

Aus der US 2005/0007033 A1 ist eine Vorrichtung bekannt, bei der mehrere rohrförmige Körper mit entsprechenden Verbindungselementen verbunden werden, wobei in den rohrförmigen Körpern Platinen mit LEDs vorgesehen sind und sich um die Platinen eine Art Kanal ergibt.

Aufgabe der vorliegenden Erfindung ist es nun, ein System zu schaffen, bei der die von den auf einer Platine angeordneten LEDs erzeugte Wärme im Vergleich zu den aus dem Stand der Technik bekannten Vorrichtungen besser abgeführt wird und somit die Lichtausbeute und Lebensdauer der Leuchtdioden weiter verbessert wird.

Die Aufgabe wird durch ein System gemäß Anspruch 1 gelöst. Vorteilhafte Weiterbildungen der Erfindung sind Gegenstand der abhängigen Ansprüche.

Erfindungsgemäß wird ein System zur Beleuchtung vorgeschlagen, bei dem mindestens zwei Anordnungen zur Lichtabgabe durch ein Verbindungselement in Längsrichtung miteinander verbunden sind, wobei die Kanäle der Anordnungen miteinander in Verbindung stehen. Die Anordnungen zur Lichtabgabe weisen jeweils mehrere Leuchtdioden auf einer Platine, sowie einen Kanal zur Durchführung eines Kühlmediums auf, wobei jede Platine als hohles, vorzugsweise längliches Element ausgestaltet ist und die gesamte Kanalwand unmittelbar durch die Platine gebildet wird, wobei die Platine vorzugsweise einen rechteckigen Querschnitt aufweist.

Hierdurch ist es nun möglich, dass ein Kühlmedium wie Luft oder Wasser direkt an der Rückseite, also der den Leuchtdioden gegenüberliegenden Seite, der LED-Platine entlang strömen kann und somit in engem Kontakt mit den LEDs als Wärmequellen steht. Das Kühlmittel gelangt also unmittelbar an die Stelle der Wärmeentstehung und kann daher die Wärme deutlich besser und schneller abführen als dies aus dem Stand der Technik bekannt ist.

Vorteilhafterweise, ist das Verbindungselement hohl ausgebildet und weist einen Kanal zur Durchführung eines Kühlmediums auf.

Hierdurch ergibt sich nun die Möglichkeit, dass eine beliebige Anzahl von Anordnungen zur Lichtabgabe miteinander verbunden werden können und diese gleichzeitig einen zusammenhängenden Kanal zur Durchführung eines Kühlmediums bilden.

Vorzugsweise erstreckt sich der Kanal entlang der Anordnung der LEDs wobei die LEDs in einer geraden, zickzack- oder wellenförmigen Reihe angeordnet sein können. Jede Anordnung kann vorzugsweise eine Länge von 300 mm und eine Breite von etwa 30 mm aufweisen, wobei der Kanal mindestens eine Höhe von 2 mm vorzugsweise jedoch etwa 5 mm aufweist.

Nachfolgend soll die Erfindung anhand von Ausführungsbeispielen und den beiliegenden Zeichnungen näher erläutert werden. Es zeigen:
- Figur 1: eine perspektivische Ansicht eines ersten Ausführungsbeispiels einer Anordnung zur Lichtabgabe;
- Figur 2: den Querschnitt eines ersten Ausführungsbeispiels einer Anordnung zur Lichtabgabe;
- Figur 3: den Querschnitt eines zweiten Ausführungsbeispiels einer Anordnung zur Lichtabgabe;
- Figur 4: den Querschnitt eines dritten Ausführungsbeispiels einer Anordnung zur Lichtabgabe;
- Figur 5: eine perspektivische Ansicht des erfindungsgemäßen Systems zur Beleuchtung mit zwei Anordnungen zur Lichtabgabe und einem Verbindungselement in getrenntem Zustand;
- Figur 6: die Ansicht des in Figur 5 gezeigten Systems zur Beleuchtung im zusammengebauten Zustand;
- Figur 7: eine perspektivische Ansicht eines Leuchtengehäuses mit einer in dem Leuchtengehäuse angeordneten Anordnung zur Lichtabgabe.

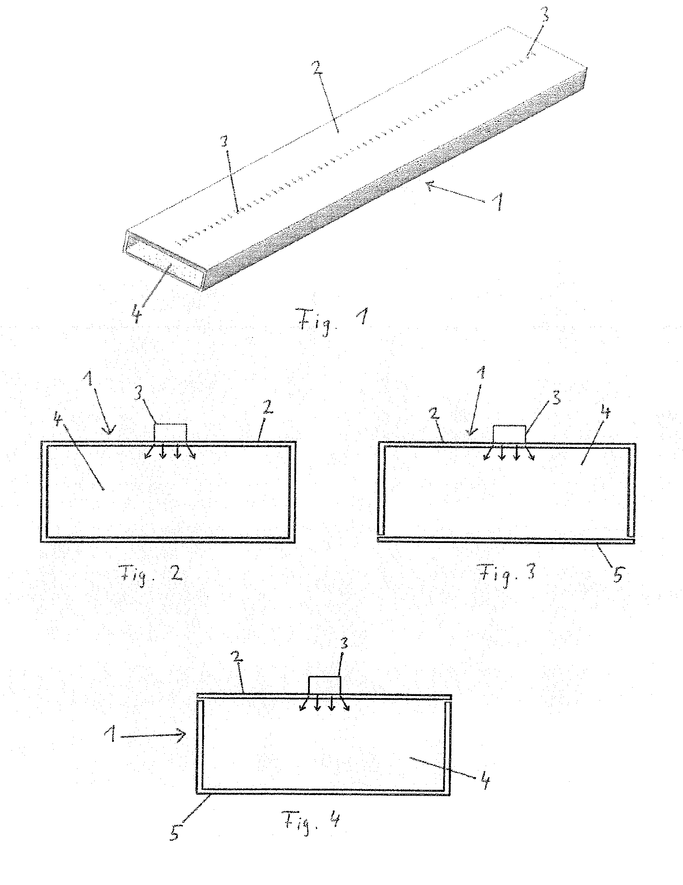

Figur 1 zeigt eine Anordnung 1 zur Lichtabgabe mit mehreren Leuchtdioden 3, die auf einer Platine 2 angeordnet sind, sowie einen Kanal 4 zur Durchführung eines Kühlmediums. Wie aus Figur 1 hervorgeht ist die Platine 2 als hohles längliches Element ausgebildet, wodurch die gesamte Kanalwand unmittelbar durch die Platine 2 gebildet wird. Die Platine 2 als Träger der Leuchtdioden 3 ist dementsprechend direkt als Kühlkanal ausgeführt, wodurch das Kühlmedium direkt an die LEDs 3 als Wärmequellen heranströmen kann und hierdurch die entstehende Wärme sehr effizient ableiten kann. Als Kühlmedium sind hier beispielsweise Wasser oder Luft denkbar, wobei auch andere Kühlmedien zum Einsatz kommen könnten.

Die Platine 2 kann aus jedem denkbaren Leiterplattenmaterial gebildet werden, da es nun nicht mehr zwingend erforderlich ist, Materialien zu verwenden, die besonders gut thermisch leitfähig sind. Dies ist insbesondere darauf zurückzuführen, dass nunmehr das Kühlmedium sehr nah an die Wärmequellen gelangt und dementsprechend unabhängig von dem Platinenmaterial eine gute Wärmeabfuhr gewährleistet ist.

In Figur 2 ist die in Figur 1 gezeigte Anordnung im Querschnitt dargestellt. Wie in Figur 2 exemplarisch mit Hilfe der Pfeile angedeutet, wird die von den Leuchtdioden 3 erzeugte Wärme an den Kühlkanal 4 abgegeben, durch den ein Kühlmedium fließt, wodurch die Wärme verhältnismäßig schnell abgeführt werden kann.

In den Figuren 3 und 4 sind jeweils andere Ausführungsformen der Anordnung 1 zur Lichtabgabe gezeigt, die hier beispielhaft zur besseren Erläuterung dienen, jedoch nicht Bestandteil des erfindungsgemäßen Systems zur Beleuchtung sind. In Figur 3 ist vorgesehen, dass die Platine u-förmig ausgebildet ist, wobei die Leuchtdioden 3 an der Außenseite der u-förmigen Platine angebracht sind. Um nun einen Kanal 4 zu bilden wird die u-förmige Platine 2 durch eine flache Abdeckung 5 abgedeckt, wodurch sich eine vergleichbare Anordnung 1 zur Lichtabgabe wie in den Figuren 1 und 2 ergibt.

Im Gegensatz hierzu ist die Platine 2 in Figur 4 lediglich flach ausgebildet. Um wiederum einen Kanal 4 zu bilden, ist an der den LEDs 3 gegenüberliegenden Seite der Platine 2 eine u-förmige Abdeckung 5 angebracht. Auch hier ergibt sich wieder eine ähnliche Anordnung 1 zur Lichtabgabe wie in den Figuren 1 und 2.

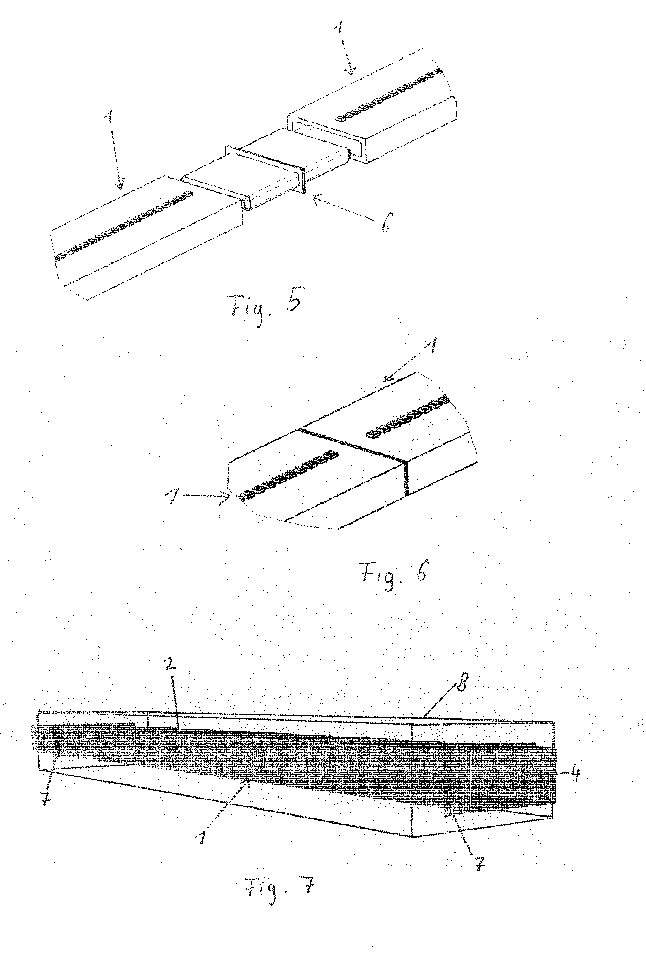

In den Figuren 5 und 6 ist ein erfindungsgemäßes System zur Beleuchtung gezeigt, bei dem zwei Anordnungen 1 zur Lichtabgabe mit Hilfe eines erfindungsgemäßen Verbindungselements 6 in Längsrichtung zusammengefügt werden. Hierbei ist das Verbindungselement 6 hohl ausgebildet, wodurch es einen Kanal zur Durchführung eines Kühlmediums aufweist. Somit sind die einzelnen Kanäle 4 der Anordnungen 1 miteinander verbunden, wodurch ein langer durchgehender Kühlkanal entsteht. Durch diese Verbindungselemente 6 ist es möglich, lediglich einige Standardlängen der Anordnungen 1 zur Lichtabgabe herzustellen und trotzdem äußerst flexibel bezüglich der Länge zu sein.

Eine bevorzugte Anwendung ergibt sich auch bei Leuchten sogenannter höherer Schutzart, bei denen eine Abdichtung gegenüber der Umgebung gefordert ist. Figur 7 zeigt eine derartige Leuchte, bei der in einem Leuchtengehäuse 8 eine Anordnung 1 zur Lichtabgabe angeordnet ist. Da nunmehr die Platine 2 selbst den Kühlkanal 4 bildet, kann vorgesehen sein, dass sich diese durch das Gehäuse 8 der Leuchte hindurch erstreckt und an den Seitenwänden leicht übersteht. Hier ist dann ohne Weiteres eine Abdichtung 7 zwischen der Platine 2 und der Gehäusewand möglich, sodass letztendlich von der Außenseite her in einfacher Weise das Kühlmedium zugeführt werden kann.

## Patentansprüche

1. System zur Beleuchtung mit
• mindestens zwei Anordnungen (1) zur Lichtabgabe und
• mindestens einem Verbindungselement (6),
wobei jede Anordnung (1) zur Lichtabgabe mehrere Leuchtmittel in Form von LEDs (3), die auf einer Platine (2) angeordnet sind, sowie einen Kanal (4) zur Durchführung eines Kühlmediums aufweist und wobei die Anordnungen (1) zur Lichtabgabe durch das Verbindungselement (6) in Längsrichtung miteinander verbunden sind,
**dadurch gekennzeichnet,**
**dass** die Kanäle (4) der Anordnungen (1) zur Lichtabgabe miteinander in Verbindung stehen und dass jede Platine (2) als hohles, vorzugsweise längliches Element ausgestaltet ist und die gesamte Kanalwand unmittelbar durch die Platine (2) gebildet wird, wobei die Platine (2) vorzugsweise einen rechteckigen Querschnitt aufweist.

2. System nach Anspruch 1,
**dadurch gekennzeichnet,**
**dass** die LEDs (3) in einer geraden, zickzack- oder wellenförmigen Reihe angeordnet sind, wobei sich der Kanal (4) entlang der Anordnung der LEDs (3) erstreckt.

3. System nach einem der vorherigen Ansprüche,
**dadurch gekennzeichnet,**
**dass** jede Platine (2) eine Länge von etwa 300 mm und ein Breite von etwa 30 mm aufweist und der Kanal mindestens 2 mm, vorzugsweise 5 mm hoch ist.

4. System nach einem der vorherigen Ansprüche,
**dadurch gekennzeichnet,**
**dass** das Verbindungselement (6) hohl ausgebildet ist und einen Kanal zur Durchführung eines Kühlmediums aufweist.

5. System nach einem der vorherigen Ansprüche,
**dadurch gekennzeichnet,**
**dass** das Verbindungselement (6) einen rechteckigen Querschnitt aufweist.

## Claims

1. A system for illumination having
• at least two arrangements (1) for light-emission, and
• at least one connecting element (6),
wherein each arrangement (1) for light-emission has a plurality of luminous means in the form of LEDs (3) which are arranged on a printed circuit board (2), and also a channel (4) for feeding through a coolant, and wherein the arrangements (1) for light-emission are connected together in the longitudinal direction by means of the connecting element (6),
**characterised in that**
the channels (4) of the arrangements (1) for light-emission communicate with each other, and each printed circuit board (2) is configured as a hollow, preferably elongate element, and the whole channel wall is formed directly by the printed circuit board (2), wherein the printed circuit board (2) preferably has a rectangular cross-section.

2. A system according to claim 1,
**characterised in that**
the LEDs (3) are arranged in a straight, zigzagging or undulating row, wherein the channel (4) extends along the arrangement of the LEDs (3).

3. A system according to one of the previous claims,
**characterised in that**
each printed circuit board (2) has a length of approximately 300 mm and a width of approximately 30 mm, and the channel is at least 2 mm, preferably 5 mm, high.

4. A system according to one of the previous claims,
**characterised in that**
the connecting element (6) is formed so as to be hollow and has a channel for feeding through a coolant.

5. A system according to one of the previous claims,
**characterised in that**
the connecting element (6) has a rectangular cross-section.

## Revendications

1. Système d'éclairage avec
- au moins deux agencements (1) ou émission de lumière et
- au moins un élément de liaison (6),
chaque agencement (1) d'émission de lumière comporte plusieurs moyens d'éclairage sous forme de DEL (3), disposées sur une platine (2), ainsi qu'un canal (4) pour le passage d'un agent de refroidissement et sachant que les agencements (1) d'émission de lumière sont reliés entre eux dans une direction longitudinale par l'élément de liaison (6),
**caractérisé en ce que**
les canaux (4) des agencements (1) d'émission de lumière sont reliés entre eux et **en ce que** chaque platine (2) est agencée en tant qu'élément creux de préférence longitudinal et la paroi complète des canaux est formée directement par la platine (2), la platine (2) présentant de préférence une section transversale rectangulaire.

2. Système selon la revendication 1,
**caractérisé en ce que**
les DEL (3) sont disposées selon une ligne droite, une ligne en zigzag ou une ligne de forme ondulée, le canal (4) s'étendant le long de l'agencement des DEL (3).

3. Système selon l'une quelconque des revendications précédentes,
**caractérisé en ce que**
chaque platine (2) présente une longueur de 300 mm environ et une largeur de 30 mm environ et le canal présente une hauteur au moins de 2 mm, de préférence de 5 mm.

4. Système selon l'une quelconque des revendications précédentes,
**caractérisé en ce que**
l'élément de liaison (6) est creux et comprend un canal pour le passage d'un agent de refroidissement.

5. Système selon l'une quelconque des revendications précédentes,
**caractérisé en ce que**
l'élément de liaison (6) présente une section transversale rectangulaire.
